# EUROPÄISCHE PATENTSCHRIFT

(11) **EP 2 299 596 B1**
(45) Veröffentlichungstag und Bekanntmachung des Hinweises auf die Patenterteilung: **25.02.2015**
(21) Anmeldenummer: 10169430.5
(22) Anmeldetag: 13.07.2010
(51) Int. Cl.: H03K 17/96, H01L 41/04, G07C 9/00

(54) **Betätigungseinrichtung für ein Kraftfahrzeug**
Actuation device for a motor vehicle
Dispositif d'actionnement pour un véhicule automobile

(30) Priorität: 16.09.2009 DE 102009029500
(43) Veröffentlichungstag der Anmeldung: 23.03.2011
(73) Patentinhaber: Huf Hülsbeck & Fürst GmbH & Co. KG, 42551 Velbert (DE)
(72) Erfinder: Witte, Martin, 48683 Ahaus (DE); Peschl, Andreas, 42549 Velbert (DE)
(74) Vertreter: Zenz

(56) Entgegenhaltungen:
- EP-A1- 1 795 674
- US-A1- 2004 016 298
- US-A1- 2006 028 095
- US-A1- 2008 079 537
- US-A1- 2009 146 533

## Beschreibung

Die Erfindung betrifft eine Betätigungseinrichtung bzw. Bedienungseinrichtung für ein Kraftfahrzeug, wobei die Bedienungseinrichtung zur Überwachung eines Benutzerzugriffs dient. Die Bedienungseinrichtung weist einen Piezo-Sensor auf, welcher zur Registrierung einer Druckbetätigung oder Tastbetätigung mit einer Druckfläche gekoppelt ist, auf welche ein Benutzer zugreifen kann.

An verschiedenen Zugriffspunkten eines Kraftfahrzeuges und zu vielerlei Zwecken sind Bedienungseinrichtungen für einen Benutzerzugriff angeordnet. Ein Benutzer kann einen Schaltvorgang oder eine sonstige Funktion des Kraftfahrzeuges initiieren, wobei die Bedienungseinrichtungen in aktuellen Fahrzeugen oft elektrische oder elektronische Komponenten verwenden, um wenigstens ein Glied in der Betätigungskette zu bilden. Rein mechanisch arbeitende Bedienungseinrichtungen sind nur noch selten an Fahrzeugen aufzufinden. Zur Registrierung eines Bedienungszugriffes gibt es vielfältige Arten von Bedienungseinrichtungen. Bei manchen Einrichtungen werden einfache Kontaktschalter verwendet, in anderen Anwendungen werden jedoch auch Bedieneinrichtungen mit kapazitiven Sensoren eingesetzt oder Sensoren, welche den Piezoeffekt nutzen.

Zur Verwendung des Piezoeffekts in einem Sensor werden geeignete piezoelektrische Materialien (Quarz oder z.B. Bariumtitanat) verwendet. Derartige Materialien zeigen den sogenannten direkten Piezoeffekt, der bei mechanischer Verformung eines Materialstückes eine abgreifbare elektrische Spannung an dem Materialstück aufbaut. In anderen Einrichtungen werden piezoaktive Materialien als Schwingquarze verwendet, deren Verstimmung durch einen Benutzerzugriff registriert wird und als Sensorsignal verwendet wird.

Im Kraftfahrzeugbereich ist es auch bekannt, Piezo-Sensoren mit kapazitiven Sensoren zu kombinieren, um sowohl eine kurzzeitige Betätigung und andererseits eine anhaltende Betätigung detektieren zu können. Außerdem erlauben kapazitive Sensoren, die Annäherung eines Benutzers zu erfassen, im Gegensatz zu Piezo-Sensoren. Eine derartige Kombination aus kapazitivem Sensor mit Piezo-Sensor ist beispielsweise der DE 10 2005 061 754 A1 zu entnehmen.

Piezo-Sensoren haben gegenüber kapazitiven Sensoren den Vorteil, dass sie im geringeren Maße von Umweltbedingungen abhängig sind, wie z.B. Tau oder Regen im sensierten Bereich, und daher verlässlichere Signale liefern. Da die Piezo-Signale jedoch kurzzeitige, pulsartige Signale sind, ist ein umfassender Einsatz in Bedienvorrichtungen ohne den zusätzlichen Einsatz von Sensoren zur Erfassung von Dauerbetätigungen nicht möglich.

Das Dokument US 2009/0146533 offenbart eine kraftsensierende Sensoranordnung mit einem Piezo-Element. Das Piezo-Element weist je nach einwirkendem Druck unterschiedliche Kapazität auf, welche durch eine Messanordnung ermittelt wird, indem eine Zeitkonstante für einen Ladevorgang gemessen wird.

Eine Differenzierung, welcher Art eine Betätigung ist, insbesondere ob es sich um die Betätigung durch einen Benutzer handelt, ist jedoch nicht möglich.

Der Erfindung liegt die Aufgabe zugrunde, eine verbesserte und vereinfachte Bedienvorrichtung zur Verfügung zu stellen, welche in besonders verlässlicher Weise eine Betätigung durch einen Benutzer erfasst.

Diese Aufgabe wird erfindungsgemäß gelöst durch eine Einrichtung mit den Merkmalen des Patentanspruchs 1 sowie durch ein zugehöriges Verfahren mit den Merkmalen des Patentanspruchs 8.

Die erfindungsgemäße Einrichtung der eingangs genannten Art ist gekennzeichnet durch eine Ladeschaltung, die zum Aufladen des Piezo-Sensors mit diesem gekoppelt ist. Durch die Ladeschaltung kann der Sensor aufgeladen werden, bis ein vorgegebener Spannungswert zwischen den Enden des Piezo anliegt.

Weiterhin ist eine Erfassungs- und Analyseeinrichtung mit dem Piezo-Sensor gekoppelt, die eine am Piezo-Sensor anliegende Spannung in digitale Werte wandeln und eine Folge von gewandelten Spannungswerten wenigstens kurzfristig aufzeichnen kann. Eine Steuereinrichtung ist über einen weckfähigen Eingang mit dem Piezo-Sensor gekoppelt und kann die Erfassungs- und Analyseeinrichtung aktivieren.

Die Bedieneinrichtung gemäß der Erfindung wirkt folgendermaßen:
Wird der Piezo-Sensor durch einen Bediener betätigt (z.B. mit Druck beaufschlagt), bewirkt dies eine Ladungsverschiebung in dem Piezo-Sensor und eine abgreifbare Spannung am Sensor wird erzeugt. Wird vom Bediener weiterhin eine anhaltende Betätigung bzw. ein anhaltender Druck ausgeübt, kann dies gemäß der Erfindung erfasst werden, denn die Betätigung durch einen Benutzer findet aufgrund der jederzeit vorhandenen wechselnden Muskelspannung, also der Kontraktion und Relaxation, niemals mit gleichbleibendem Druck statt. Entsprechend ändert sich die am Piezo-Sensor anliegende Spannung entsprechend der wechselnden Muskelspannung bzw. dem wechselnden Druck auf den Sensor.

Erfindungsgemäß ist die Bedienungseinrichtung mit einer Ladeeinrichtung bzw. Ladeschaltung versehen, welche den Piezo in einem vorgegebenen Ladungszustand bringen kann, bei dem zwischen seinen Enden eine gewünschte Offset-Spannung anliegt. Diese erfindungsgemäße Maßnahme bringt den Vorteil, dass problemlos sowohl Spannungserhöhungen als auch Spannungserniedrigungen um die Offset-Spannung herum erfasst und einer Analyse zugeführt werden können. Kleinste Bewegungen des Benutzers, die auch dann auftreten, wenn der Benutzer um eine ruhige Handhabung bemüht ist, erzeugen positive oder negative Ladungen im Piezo und führen zu einer Spannungsänderung. Es wird eine rauschende Wechselspannung um den gewünschten Offset-Wert erzeugt, die einer Analyse in einfacher Weise zugänglich ist und eine Anwesenheit des Bedieners signalisiert. Die Empfindlichkeit bei dieser Erfassung kann über die Ladungsmenge, die auf dem Piezo gebracht wird, eingestellt werden. Wird der Piezo z.B. auf eine geringere Ladung (geringere resultierende Spannung) aufgeladen, ist das System empfindlicher als bei einer höheren Spannung (z.B. 5 Volt).

Erfindungsgemäß wird nicht ein einzelner Spannungswert ausgewertet, sondern eine Folge von mehreren aufeinanderfolgenden Spannungswerten wird als Spannungsverlauf erfasst und ausgewertet. Die Abtastung findet dabei mit vorgegebener Frequenz statt, z.B. mit einer Frequenz von 1 kHz und die Spannungsverläufe werden über eine Zeitspanne von einigen Millisekunden bis hin zu mehreren Sekunden überwacht. Auf diese Weise können Fehlbetätigungen (z.B. aufgrund von Stößen oder Schlägen auf den Sensor) von einer Benutzerbetätigung unterschieden und ausgeschlossen werden. Anhand der Signalverläufe können nämlich störende Einflüsse erkannt werden. So weisen z.B. unbeabsichtigte Stöße (herabfallende Äste oder Kontakt des parkenden Fahrzeugs mit Passanten) regelmäßig scharfe Spannungsausschläge mit relativ glatten Rückgängen auf das Ursprungsnivea6u auf, während eine Benutzerbetätigung aufgrund der genannten schwankenden Druckstärke eine stark rauschende Spannungskurve abgibt.

Anhand der ermittelten Spannungskurve ist es erfindungsgemäß möglich, mit der Analyseeinrichtung die Art der Betätigung zu differenzieren.

Für die Anwendung der Erfindung gilt, dass zur Signalanalyse beliebige bekannte Verfahren eingesetzt werden können, insbesondere kann die Amplitude der Spannungsschwankungen ausgewertet werden sowie die Frequenz der Schwankungen. Dazu ist beispielsweise eine einfache Fourier-Analyse durchzuführen, um charakteristische Spannungsschwankungsfrequenzen zu ermitteln. Es ist bekannt, dass angespannte Muskeln, z.B. bei der Betätigung eines Tastschalters, einen sogenannten Aktions-Tremor bzw. Aktivitäts-Tremor aufweisen, also ein anspannungsbedingtes Muskelzucken. Derartiges Muskelzucken kann aus den Spannungswerten herausgefiltert werden, da es üblicherweise Frequenzen von ca. 10 -40 Hz aufweist. Das Vorliegen eines eindeutigen Frequenzanteils in diesem Bereich kann beispielsweise zur Feststellung einer Benutzerbetätigung verwendet werden.

Die Ladeeinrichtung wird von der Steuereinrichtung in Abhängigkeit von dem aktuellen, gewandelten Spannungswert angesteuert, um den Piezo kontinuierlich auf einer gewünschten Offset-Spannung zu halten.

Die Signalanalyse kann jedoch auch um Auswertungen der Daten der Aufladung des Piezo-Sensors ergänzt werden oder sogar gänzlich durch diese ersetzt werden. Wird die Ladeschaltung kontinuierlich betrieben und derart angesteuert, dass sie den Ladezustand zum Erzielen eines gewünschten Spannungswertes am Piezo aufrechterhält, so kann die geflossene Ladung als Maß für die Ladungsverschiebungen im Piezo verwendet werden. Durch anhaltende Betätigung des Sensors findet eine Aufladung und Entladung im Wechsel statt, so dass die Ladeschaltung ständig regeln muss, um zeitweise die Ladung vom Piezo-Sensor abzuziehen und andererseits zeitweise auf diesen aufzubringen. Eine Analyse bei dieser zur Aufladung erforderlichen Ladungswerte bzw. Stromstärken und Zeitdauern kann ebenfalls zur Erfassung einer Benutzerbetätigung verwendet werden.

Die Steuereinrichtung weist außerdem einen weckfähigen Eingang auf, der mit dem Piezo-Sensor gekoppelt ist. Erfindungsgemäß wird an dem weckfähigen Eingang der Steuereinrichtung bei einer ersten Betätigung des Piezos und einem daraus resultierenden Spannungspuls die Steuereinrichtung geweckt und in einen Abfragezustand versetzt. Die Steuereinrichtung kann nun die Analyseeinrichtung aktivieren bzw. mit deren Ansteuerung beginnen. Es braucht daher nicht ununterbrochen die Spannung an dem Piezo abgefragt zu werden, sondern nur, wenn die Steuereinrichtung durch einen Spannungspuls an dem weckfähigen Eingang geweckt wurde. Erst dann beginnt die Signalanalyse der am Piezo anliegenden Spannung. Wird die Ladeschaltung nicht kontinuierlich betrieben, wird zuvor auch die Ladeschaltung von der Steuereinrichtung aktiviert, um am Piezo die gewünschte Offset-Spannung durch Aufladung einzustellen. Anschließend wird von der Erfassungs- und Analyseeinrichtung die Spannung am Piezo mit gewünschter Frequenz abgetastet und der entsprechende Signalverlauf erfasst. Dieser Signalverlauf wird in digitale Werte gewandelt und auf charakteristische Merkmale untersucht. Insbesondere kann zunächst untersucht werden, ob ein anfänglicher Betätigungspuls eine Breite aufweist, die in einem Wertebereich liegt, welcher eine einsetzende Benutzerbedienung als gültig erkennt (üblicherweise z.B. 50 - 100 ms). Im Weiteren kann der Kurvenverlauf weiter analysiert werden, um eine anhaltende Betätigung des Benutzers zu erfassen.

Durch die Aufladung des Piezo-Sensors wird erfindungsgemäß eine Bedienungseinrichtung geschaffen, welche ohne weitere Sensorkomponenten und allein unter Verwendung eines Piezo-Sensors die Erfassung einer Dauerbetätigung erlaubt.

In einer bevorzugten Weiterbildung der Bedienungseinrichtung weist die Steuereinrichtung einen Mikrocontroller auf, wobei ein Signal an dem weckfähigen Eingang ein Interrupt in dem Mikrocontroller auslösen kann.

Die Verwendung eines Mikrocontrollers in der erfindungsgemäßen Bedienungseinrichtung ist vorteilhaft, da handelsübliche Mikrocontroller die von der Erfindung verwendeten Eingänge regelmäßig bereits aufweisen. Insbesondere weist ein derartiger Mikrocontroller weckfähige Eingänge auf und kann durch einfache Anpassung der ablaufenden Software zur Ansteuerung der Analyseeinrichtung bzw. selbst zur Ausführung von Analysefunktionen programmiert werden.

Der Mikrokontroller kann auch wesentliche Aufgaben der Ladeschaltung übernehmen oder die Ladeschaltung kann vollständig im Mikrokontroller implementiert sein. Auf diese Weise kann der Mikrokontroller daher die Steuereinrichtung, die Ladeschaltung und die Analyseeinrichtung in sich vereinigen.

In einer Weiterbildung ist die Steuereinrichtung auch mit der Ladeschaltung gekoppelt, um diese zur Aufladung des Piezo-Sensors anzusteuern.

Es ist vorteilhaft, wenn die Steuerschaltung die Ladeschaltung den Piezo-Sensor nicht kontinuierlich in Abhängigkeit vom gewandelten Spannungswert auf einen vorgegebenen Ladungszustand auflädt, sondern dies nur dann veranlasst, wenn die Steuereinrichtung (z.B. der Mikrocontroller) geweckt wurde und ein Betätigungsereignis am Sensor ansteht. Erst dann, wird der Sensor kurzfristig aufgeladen (z.B. auf 50-150 mV) und steht mit erhöhter Empfindlichkeit sowohl zur Analyse von ansteigenden als auch abfallenden Spannungen zur Verfügung.

Bei mehrteiliger Ausbildung der Analyseeinrichtung einerseits und Steuereinrichtung andererseits kann die Analyseeinrichtung der Steuereinrichtung die erfassten Spannungswerte zur Verfügung stellen, um der Steuereinrichtung weitergehende Auswertungen oder eine Ansteuerung beispielsweise der Ladeschaltung zu ermöglichen. Die Spannungswerte können einerseits zur Erfassung der Betätigung verwendet werden und andererseits, um die Ladeschaltung anzusteuern, damit ein vorgehender Ladezustand eingehalten wird.

In einer besonders bevorzugten Ausführungsform sind Steuereinrichtungen und Analyseeinrichtungen in demselben Mikrocontroller implementiert. In diesem Fall sind die beiden Einrichtung untrennbar verbunden, beispielsweise als Teile eines auf dem Mikrocontroller ausgeführten Programms, welches sowohl Analysefunktionalität als auch Steuerfunktionalität aufweist.

In einem weitern Aspekt der Erfindung wird ein Verfahren zur Erfassung einer Betätigung einer Bedienungseinrichtung an einem Kraftfahrzeug vorgeschlagen, wobei die Bedienungseinrichtung einen Piezo-Sensor aufweist, der zur Druckbetätigung oder Tastbetätigung durch einen Benutzer angeordnet ist und mit einer Druckfläche gekoppelt ist.

Wesentliche Schritte des Verfahrens bestehen darin, dass eine am Piezo-Sensor anliegende Spannung überwacht wird, wobei dann, wenn ein vorgegebener Spannungswert am Piezo-Sensor überschritten wird, ein Interrupt in einem Mikrocontroller ausgelöst wird. In Reaktion auf die Auslösung des Interrupt wird die Piezospannung abgetastet, wobei dann, wenn die Piezospannung einen Signalverlauf mit charakteristischen Merkmalen zeigt, eine Benutzerbedienung erkannt wird. Ein derartiger Signalverlauf kann z.B. hinsichtlich der Pulsweite, der Schwankungsfrequenz oder ähnlichem analysiert werden.

Anschließend wird in dem Fall, in dem eine Benutzerbedienung erkannt wird, ein Funkdialog zur Zugriffskontrolle in Reaktion auf die Benutzerbedienung initiiert, wobei eine Kommunikation zwischen dem Fahrzeug und einem vom Benutzer mitgeführtem ID-Geber abläuft. Es erfolgt außerdem ein fortgesetztes Abtasten der Piezospannung, wobei ein zeitlicher Signalverlauf der Spannung digitalisiert und einer Signalanalyse unterzogen wird, und dann, wenn der Signalverlauf eine anhaltende Bedienung des Piezo-Sensors anzeigt, ein Bedienungssignal ausgegeben wird.

Mit dem erfindungsgemäßen Verfahren und dem darin angegebenen Schritten ist eine Zugriffskontrolle, z.B. an einem Kraftfahrzeugtürgriff in komfortabler Weise zu realisieren. Ein Benutzer betätigt ein Bedienelement, z.B. eine Tastfläche an einem Kraftfahrzeugtürgriff, wobei die Tastfläche mit einem Piezo-Sensor gekoppelt ist und den Tastdruck auf diesen überträgt. Dieser auftretende Tastdruck weckt einen Mikrocontroller auf, welcher die am Sensor anliegende Piezospannung abtastet und die Pulsweite des entstehenden Spannungspulses erfasst. Für den Fall, dass sich eine charakteristische Pulsweite zeigt, wird ein vom Kraftfahrzeug ein Autorisierungstelegramm mit charakteristischen Daten über Sendeantennen am Kraftfahrzeug ausgesendet. Befindet sich ein autorisierter ID-Geber im Empfangsbereich und antwortet dieser auf das entsprechende Telegramm, kann eine Autorisierungsnachricht an das Kraftfahrzeug vom ID-Geber zurückgesendet werden. Das fortgesetzte Abtasten der Piezospannung am Türgriff überprüft, ob eine anhaltende Betätigung des Tasters (z.B. für mehr als 0,5 s) anhält, und in Abhängigkeit davon kann die Sperreinrichtung der betreffenden Tür freigegeben werden.

Die Erfindung wird nun anhand der beiliegenden Zeichnung näher erläutert.
Figur 1 zeigt charakteristische Spannungsverläufe am Piezo-Sensor.
Figur 2 zeigt einen schematischen Aufbau der erfindungsgemäßen Einrichtung.

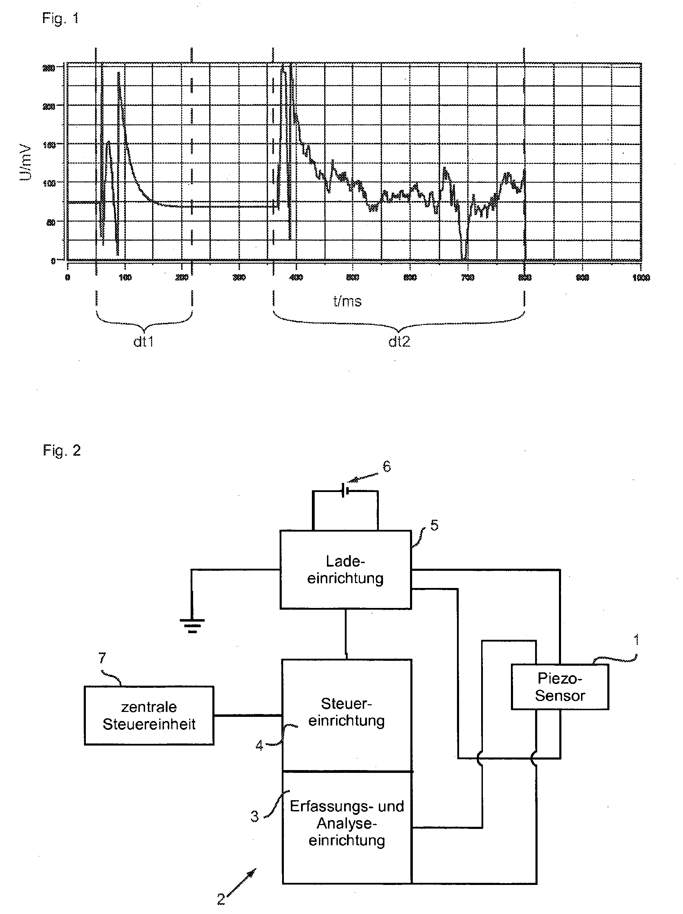

In Figur 1 ist ein zeitlicher Verlauf eines bei einer erfindungsgemäßen Einrichtung am Piezo-Sensor abgegriffenen Spannungssignals dargestellt. Es ist ersichtlich, dass der Piezo-Sensor zunächst, d.h. zum Zeitpunkt t=0 ms, aufgeladen wird, so dass eine Offset-Spannung von 75 mV zwischen den Sensor-Enden anliegt. In dem zeitlichen Signalabschnitt dt1 ist ein Spannungssignalverlauf erkennbar, welcher beispielsweise durch einen Stoß, z.B. durch einen am Sensor anschlagenden Gegenstand (z.B. Regenschirm oder Einkaufswagen) erzeugt wird. Nach kurzen scharfen Ausschlägen kehrt die am Piezo-Sensor anliegende Spannung in einer glatten Kurve auf die Offset-Spannung zurück, welche sie am Ende des Zeitintervalls dt1 (bei etwa 210 ms) erreicht.

Im Gegensatz dazu ist im Zeitintervall dt2 der Spannungssignalverlauf am Piezo-Sensor bei einer Bedienerbetätigung mit anhaltendem Druck auf dem Piezo-Sensor dargestellt. Es wird deutlich, dass zunächst ebenfalls ein kräftiger Signalausschlag erfolgt, wobei anschließend die Ladeeinrichtung den Piezo-Sensor auflädt oder entlädt, um wieder die Offset-Spannung von 75 mV einzustellen. Um diese Offset-Spannung schwankt die Spannung mit kräftigem Rauschen und einzelnen Ausschlägen, was eine anhaltende Betätigung durch den Benutzer signalisiert, der weiterhin Druck ausübt. Die Spannungsschwankungen werden insbesondere durch den Muskeltremor des Benutzers verursacht.

Während der gesamten Zeitdauer ist die Ladeeinrichtung aktiv und versucht, den Ladezustand des Piezo wieder derart einzustellen, dass die Offset-Spannung gehalten wird.

Es ist unmittelbar ersichtlich, dass die jeweiligen Signalverläufe mit einer einfachen Signalanalyse in bekannter Weise zu unterscheiden sind, insbesondere wenn beispielsweise das Rauschverhältnis oder die Schwankungsfrequenz der Spannung mit bekannten Analysemethoden (z.B. Signal-Rausch-Abstand(SNR) oder Fourier-Analyse)ausgewertet wird. Auf diese Weise kann verlässlich eine anhaltende Betätigung, wie sie im Zeitraum dt2 vorliegt, von einer versehentlichen Betätigung oder einem Umwelteinfluss, wie er beispielsweise in dt1 gezeigt ist, unterschieden werden.

Die Figur 2 zeigt in schematischer Weise die erfindungsgemäße Bedienungseinrichtung. Ein Piezo-Sensor 1 ist mit einem Mikroprozessor 2 gekoppelt. Im Mikroprozessor ist sowohl die Erfassungs- und Analyseeinrichtung 3 implementiert, als auch die Steuereinrichtung 4. Der Piezo-Sensor 1 ist mit einem weckfähigen Eingang des Mikroprozessors 2 verbunden, um die Erfassungseinrichtung 3 und die Steuereinrichtung 4 aktivieren zu können. Im Kopplungsweg zwischen den Piezo-Sensor und dem Mikroprozessor können weitere elektrische und elektronische Komponenten angeordnet sein, die hier jedoch aus Gründen der Übersichtlichkeit nicht dargestellt sind. Diese Komponenten kann ein Fachmann im Rahmen seines Fachwissens ohne weiteres zur Spannungsermittlung bzw. Interruptauslösung am Mikroprozessor ergänzen.

Der Mikroprozessor 2 ist über eine Steuerleitung mit der Ladeeinrichtung 5 gekoppelt, die über eine Spannungsquelle 6 versorgt wird. Wie oben beschrieben, kann der Mikroprozessor auch die Aufgaben der Ladeeinrichtung übernehmen, in diesem fall wären die Ladeeinrichtung 5, die Steuereinrichtung 4 und die Analyseeinrichtung 3 in einem Mikroprozessor implementiert, also als ein Teil ausgebildet. In dieser beispielhaften Darstellung sind diese funktionalen Bestandteile jedoch getrennt dargestellt, um das Funktionsprinzip näher zu erläutern. Die Ladeeinrichtung 5 kann den Piezo-Sensor auf einen gewünschten Ladungszustand aufladen, wobei eine Sollspannung am Piezo überprüft wird. Der Start der Ladeeinrichtung kann von dem Mikroprozessor über die Steuerleitung veranlasst werden. Die Ladeeinrichtung wird beispielsweise angesteuert, um einen vorgegebenen Spannungsoffset am Piezo-Sensor (z.B. 75 mV wie in Figur 1) zu halten. Dazu wird der Piezo-Sensor je nach anliegender Spannung aufgeladen oder entladen. Diese Regelung auf einen Sollwert wirkt der Spannungsschwankung durch Betätigung des Piezo-Sensors von einem Benutzer entgegen, so dass die Ladeeinrichtung bei anhaltender Benutzereinwirkung wiederholt eine Aufladung oder Entladung des Piezos durchführt. Die daraus resultierenden schwankenden oder rauschenden Spannungswerte werden vom Mikroprozessor, insbesondere der Erfassungs- und Analyseeinrichtung erfasst. Mit dem Mikroprozessor 2 ist weiterhin eine zentrale Steuereinheit 7 des Fahrzeugs gekoppelt. Erfasst der Mikroprozessor 2 eine gültige Benuterbetätigung des Piezo-Sensors 1, kann er die zentrale Steuereinheit darüber informieren und diese kann entsprechende Schaltfunktionen oder Kommunikationen mit einem vom Benutzer mitgeführten ID-Geber veranlassen.

Es ist ersichtlich, dass die Regelung des Spannungswertes durch die Ladeeinrichtung nicht schneller ablaufen sollte als die Auswertung der Piezo-Spannung, um die Ergebnisse nicht zu verfälschen. Dies gilt jedenfalls, sofern die Spannung des Piezo zur Auswertung einer Betätigung herangezogen wird. Wird die von der Ladeeinrichtung verschobene Ladung erfasst und zur Auswertung verwendet, ist diese Limitierung weniger relevant.

Im Rahmen der Erfindung sind zahlreiche Abwandlungen möglich, insbesondere können komplette und komplexe Betätigungsmuster eines Piezo-Sensors erfasst, analysiert und ausgewertet werden, wobei in Abhängigkeit eines Betätigungsmusters verschiedene Schaltfunktionen ausgelöst werden können. Des weiteren kann durch die Wahl des Soll-Ladungszustandes des Piezo-Sensors auch die Sensibilität dieses Sensors eingestellt werden, da eine höhere anliegende Offset-Spannung eine geringere Sensitivität gegenüber verformungsverursachten Schwankungen bietet.

## Patentansprüche

1. Bedienungseinrichtung für ein Kraftfahrzeug zur Überwachung eines Benutzerzugriffs, mit einem Piezo-Sensor (1), welcher zur Druckbetätigung oder Tastbetätigung durch eine Benutzer angeordnet und mit einer Druckfläche gekoppelt ist,
dass eine Ladeschaltung (5) vorgesehen ist, welche zum Aufladen des Piezo-Sensors (1) gekoppelt ist, wobei der Piezo-Sensor durch die Ladeschaltung (5) bis zum Anliegen eines vorgegebenen Spannungswertes aufladbar ist,
dass eine Erfassungs- und Analyseeinrichtung (3) mit dem Piezo-Sensor (1) gekoppelt ist, welche die am Piezo-Sensor anliegende Spannung in digitale Werte wandelt und eine Folge von gewandelten Spannungswerten aufzeichnen kann,
wobei eine Steuereinrichtung (4) über einen weckfähigen Eingang mit dem Piezo-Sensor (1) gekoppelt ist,
und wobei die Steuereinrichtung (4) die Analyseeinrichtung (3) aktivieren kann,
**dadurch gekennzeichnet,**
**dass** die Steuereinrichtung (4) die Ladeschaltung (5) in Abhängigkeit von dem aktuellen, Spannungswert ansteuert,
und **dass** die Analyseeinrichtung (3) zur Auswertung von Spannungsschwankungen der Folge von Spannungswerten zur Erfassung von wechselnder Muskelspannung eines Benutzers ausgebildet ist.

2. Bedienungseinrichtung nach Anspruch 1, wobei die Steuereinrichtung (4) einen Mikrocontroller aufweist und ein Signal an dem weckfähigen Eingang einen Interrupt in dem Mikrocontroller auslösen kann.

3. Bedienungseinrichtung nach Anspruch 1 oder 2, wobei die Steuereinrichtung (4) mit der Ladeschaltung (5) gekoppelt ist, um diese zur Aufladung des Piezo-Sensors anzusteuern.

4. Bedienungseinrichtung nach einem der vorangehenden Ansprüche, wobei ein Ausgang der Analyseeinrichtung mit der Steuereinrichtung gekoppelt ist, um einen oder mehrere Spannungswerte an die Steuereinrichtung zu übermitteln.

5. Bedienungseinrichtung nach einem der vorangehenden Ansprüche, wobei die Steuereinrichtung und die Analyseeinrichtung in demselben Mikrocontroller implementiert sind.

6. Bedienungseinrichtung nach einem der vorangehenden Ansprüche, wobei die Steuereinrichtung und die Ladeschaltung in demselben Mikrocontroller implementiert sind.

7. Bedienungseinrichtung nach einem der vorangehenden Ansprüche, wobei die Bedienungseinrichtung als Teil eines Systems zur Kontrolle einer Zugriffsberechtigung für Kraftfahrzeuge ausgebildet ist, wobei die Steuereinrichtung mit einer zentralen Steuereinheit im Fahrzeug gekoppelt ist, um in Abhängigkeit von einer am Piezo-Sensor erfassten Spannungswertefolge einen Funkdialog zur Kontrolle einer Zugriffsberechtigung eines Benutzers zu initiieren.

8. Verfahren zur Erfassung einer Betätigung einer Bedienungseinrichtung an einem Kraftfahrzeug, wobei die Bedienungseinrichtung einen Piezo-Sensor aufweist, welcher zur Druckbetätigung oder Tastbetätigung durch eine Benutzer angeordnet und mit einer Druckfläche gekoppelt ist,
mit den Schritten:
Überwachen einer am Piezo-Sensor anliegenden Spannung, wobei beim Übersteigen eines vorgegebenen Spannungswertes ein Interrupt in einem Mikrocontroller ausgelöst wird,
Fortgesetztes Abtasten der Piezospannung, wobei vor und während des fortgesetzten Abtastens der Piezospannung der Piezo-Sensor wiederholt oder kontinuierlich bis zum Erreichen eines vorgegebenen Spannungswertes aufgeladen oder entladen wird,
**dadurch gekennzeichnet, dass**
das Aufladen in Abhängigkeit von dem aktuellen Spannungswert erfolgt,
und dass ein zeitlicher Signalverlauf der Piezospannung digitalisiert und einer Signalanalyse unterzogen wird, wobei Spannungsschwankungen des Signalverlaufs zur Erfassung von wechselnder Muskelspannung eines betätigenden Benutzers ermittelt werden und dann, wenn die Signalanalyse einen für wechselnde Muskelspannung charakteristischen Signalverlauf anzeigt, ein Bedienungssignal ausgegeben wird.

9. Verfahren nach Anspruch 8, wobei eine zur Aufladung oder Entladung erforderliche Ladungsmenge wiederholt erfasst und zur Erfassung einer fortgesetzten Betätigung ausgewertet wird.

## Claims

1. An actuation device for a motor vehicle for monitoring a user access, with a piezo sensor (1), which is arranged for pressure actuation or touch actuation by a user and is coupled with a pressure surface,
that a charging circuit (5) is provided, which is coupled for charging the piezo sensor (1), wherein the piezo sensor is able to be charged by the charging circuit (5) up to the application of a predetermined voltage value,
that a detection and analysis device (3) is coupled with the piezo sensor (1), which converts the voltage applied at the piezo sensor into digital values and can record a series of converted voltage values, wherein a control device (4) is coupled with the piezo sensor (1) via an activatable input,
and wherein the control device (4) can activate the analysis device (3),
**characterized in that**
the control device (4) activates the charging circuit (5) as a function of the current voltage value,
and that the analysis device (3) is configured for the evaluation of voltage fluctuations of the series of voltage values for the detection of changing muscular tension of a user.

2. The actuation device according to Claim 1, wherein the control device (4) has a microcontroller and a signal at the activatable input is able to trigger an interrupt in the microcontroller.

3. The actuation device according to Claim 1 or 2, wherein the control device (4) is coupled with the charging circuit (5), in order to activate it for the charging of the piezo sensor.

4. The actuation device according to one of the preceding claims, wherein an output of the analysis device is coupled with the control device, in order to convey one or more voltage values to the control device.

5. The actuating device according to one of the preceding claims, wherein the control device and the analysis device are implemented in the same microcontroller.

6. The actuating device according to one of the preceding claims, wherein the control device and the charging circuit are implemented in the same microcontroller.

7. The actuating device according to one of the preceding claims, wherein the operating device is configured as part of a system for controlling an access authorization for motor vehicles, wherein the control device is coupled with a central control unit in the vehicle, in order to initiate a radio dialogue for controlling an access authorization of a user as a function of a series of voltage values detected at the piezo sensor.

8. A method for detecting an operation of an actuating device on a motor vehicle, wherein the actuating device has a piezo sensor, which is arranged for pressure actuation or touch actuation by a user and is coupled with a pressure surface,
with the steps:
monitoring a voltage applied at the piezo sensor, wherein on exceeding a predetermined voltage value an interrupt is triggered in a microcontroller,
continued scanning of the piezo voltage, wherein before and during the continued scanning of the piezo voltage the piezo sensor is repeatedly or continuously charged or discharged until a predetermined voltage value is reached,
**characterized in that**
the charging takes place as a function of the current voltage value,
and that a chronological signal progression of the piezo voltage is digitized and subjected to a signal analysis, wherein voltage fluctuations of the signal progression are determined for the detection of changing muscular tension of an operating user and then, when the signal analysis indicates a characteristic signal progression for changing muscular tension, an actuating signal is emitted.

9. The method according to Claim 8, wherein a charging quantity required for the charging or discharging is repeatedly detected and evaluated for the detection of a continued operation.

## Revendications

1. Dispositif de manipulation pour un véhicule automobile pour surveiller un accès d'utilisateur, comportant un capteur piézo (1), qui est disposé à des fins d'actionnement par pression ou actionnement par contact tactile par un utilisateur et est couplé à une surface de pression, en ce que un circuit de charge (5) est prévu, qui est couplé pour charger le capteur piézo (1), dans lequel le capteur piézo peut être chargé par le circuit de charge (5) jusqu'à c qu'une valeur de tension prescrite soit présente, en ce que un dispositif de détection et d'analyse (3) est couplé au capteur piézo (1), qui convertit la tension présente au niveau du capteur piézo en valeurs numériques et peut afficher une séquence de valeurs de tension converties, dans lequel un dispositif de commande (4) est couplé par l'intermédiaire d'une entrée à activation automatique au capteur piézo (1) et dans lequel le dispositif de commande (4) peut activer le dispositif d'analyse (3), **caractérisé en ce que** le dispositif de commande (4) commande le circuit de charge (5) en fonction de la valeur de tension actuelle et **en ce que** le dispositif d'analyse (3) est conçu afin d'évaluer les variations de tension de la séquence de valeurs de tension afin de détecter les variations de tension musculaire d'un utilisateur.

2. Dispositif de manipulation selon la revendication 1, dans lequel le dispositif de commande (4) présente un microcontrôleur et un signal sur l'entrée à activation automatique peut déclencher une interruption dans le micro-contrôleur.

3. Dispositif de manipulation selon la revendication 1 ou 2, dans lequel le dispositif de commande (4) est couplé au circuit de charge (5), afin de commander ce dernier pour charger le capteur piézo.

4. Dispositif de manipulation selon une des revendications précédentes, dans lequel une sortie du dispositif d'analyse est couplée au dispositif de commande, afin de transmettre une ou plusieurs valeurs de tension au dispositif de commande.

5. Dispositif de manipulation selon une des revendications précédentes, dans lequel le dispositif de commande et le dispositif d'analyse sont implémentés dans le même micro-contrôleur.

6. Dispositif de manipulation selon une des revendications précédentes, dans lequel le dispositif de commande et le circuit de charge sont implémentés dans le même micro-contrôleur.

7. Dispositif de manipulation selon une des revendications précédentes, dans lequel le dispositif de manipulation est conçu comme une partie d'un système de commande d'une autorisation d'accès pour véhicules automobiles, dans lequel le dispositif de commande est couplé à une unité de commande centrale dans le véhicule automobile, afin d'amorcer en fonction d'une séquence de valeurs de tension détectées sur le capteur piézo un dialogue radio pour contrôleur une autorisation d'accès d'un utilisateur.

8. Procédé de détection d'un actionnement d'un dispositif de manipulation sur un véhicule automobile, dans lequel le dispositif de manipulation présente un capteur piézo, qui est disposé à des fins d'actionnement par pression ou actionnement par contact tactile par un utilisateur et est couplé à une surface de pression, comportant les étapes consistant à :
surveiller une tension présente au niveau du capteur piézo, dans lequel en cas de dépassement d'une valeur de tension prescrite une interruption dans un micro-contrôleur est déclenchée,
un balayage continu de la tension piézo, dans lequel avant et pendant le balayage continu de la tension piézo le capteur piézo est chargé ou déchargé de manière répétée ou continue jusqu'à ce qu'une valeur de tension prescrite soit atteinte, **caractérisé en ce que** la charge est effectuée en fonction de la valeur de tension actuelle, et **en ce que** une courbe de signal temporelle de la tension piézo est numérisée et soumise à une analyse de signal, dans lequel les variations de tension de la courbe de tension sont déterminées afin de détecter les variations de tension musculaire d'un utilisateur actionnant le dispositif et ensuite, quand l'analyse de signal affiche une courbe de signal caractéristique d'une tension musculaire variable, un signal de manipulation est émis.

9. Procédé selon la revendication 8, dans lequel une quantité de charge nécessaire pour la charge ou la décharge est détectée de manière répétée et est évaluée pour détecter un actionnement continu.
